# EUROPÄISCHE PATENTSCHRIFT

(11) **EP 3 542 254 B1**
(45) Veröffentlichungstag und Bekanntmachung des Hinweises auf die Patenterteilung: **29.09.2021**
(21) Anmeldenummer: 17734261.5
(22) Anmeldetag: 16.06.2017
(51) Int. Cl.: G06F 3/041, H03K 17/96, G06F 3/044

(54) **VORRICHTUNG MIT BERÜHRUNGSEMPFINDLICHER FREIFORMFLÄCHE UND VERFAHREN ZU DEREN HERSTELLUNG**
DEVICE HAVING A TOUCH-SENSITIVE FREE-FORM SURFACE AND METHOD FOR THE PRODUCTION THEREOF
DISPOSITIF AVEC SURFACE À FORME LIBRE SENSIBLE AU TOUCHER ET SON PROCÉDÉ DE FABRICATION

(30) Priorität: 15.11.2016 DE 102016222419; 16.01.2017 DE 102017200595
(43) Veröffentlichungstag der Anmeldung: 25.09.2019
(73) Patentinhaber: Volkswagen Aktiengesellschaft, 38440 Wolfsburg (DE)
(72) Erfinder: TEMMING, Carsten, 38106 Braunschweig (DE); RHEDE, Johannes, 10115 Berlin (DE)
(86) Internationale Anmeldenummer: PCT/EP2017/064790
(87) Internationale Veröffentlichungsnummer: WO 2018/091152

(56) Entgegenhaltungen:
- EP-A2- 2 256 602
- CN-U- 203 799 363
- US-A1- 2010 103 138

## Beschreibung

Die Erfindung betrifft eine Vorrichtung zum Erfassen von Nutzereingaben über eine haptische Betätigung. Ferner betrifft die Erfindung ein Verfahren zum Herstellen einer solchen Vorrichtung.

Aus dem Stand der Technik sind Bedieneinrichtungen bekannt, die berührungsempfindliche Oberflächen aufweisen. Mit Hilfe dieser Bedieneinrichtungen können Nutzereingaben anhand der Berührposition auf einer Oberfläche erfasst werden. Bekannte Sensoren sind sogenannte Touchpads oder Touchscreens. Diese verfügen über eine Sensorfläche und können eine Berührposition auf der Sensorfläche erfassen. Diese erfasste Position wird dann als Signal bereitgestellt und kann weiterverarbeitet werden. Ist eine solche berührungsempfindliche Sensorfläche transparent ausgestaltet und vor einer freiprogrammierbaren Anzeigefläche angeordnet, so wird eine solche Kombination aus berührungsempfindlicher transparenter Oberfläche und dahinter angeordneter Anzeigefläche als Touchscreen bezeichnet. Ist die Sensoreinrichtung in der Lage, zeitgleich mehrere Berührpositionen zu erfassen, so wird eine solche Sensoreinrichtung als multitouchfähig bezeichnet.

In als Smartphone bezeichneten Mobiltelefonen, aber auch Bedienterminals von Bankautomaten etc. werden Touchscreens und Touchpads als Sensoren zur Erfassung von Nutzereingaben verwendet. Gängig sind multitouchfähige Systeme, die in der Regel auf sogenannten "mutual capacitance"-Systemen beruhen, die eine Kapazitätsänderung zwischen vorzugsweise als Zeilen und Spalten ausgebildeten und gegeneinander isolierten Elektroden auswerten, die in der Regel an einer Rückseite einer Berühr- oder Sensorfläche ausgebildet sind. Bei einem solchen Aufbau, bei dem die Elektroden auf der von der Berührung abgewandten Seite ausgebildet sind, wird ein Touchscreen als Projiziert-kapazitiver Touchscreens bezeichnet. Die Technologie wird als PCT-Technologie bezeichnet, wobei PCT ein Akronym der englischen Begriffe projected capacitive touch ist.

An vielen Stellen im Bereich der Technik ist es notwendig, Nutzereingaben zu erfassen. Je komplexer Gegenstände und Vorrichtungen werden, desto größer ist das Bedürfnis, eine Vielzahl von Nutzereingaben zu erfassen. Ein Gebiet, auf dem sich diese Entwicklung beobachten lässt, sind Kraftfahrzeuge. Während Kraftfahrzeuge früher nur eine geringe Anzahl von Bedienelementen, beispielsweise in Form von Schaltern, aufwiesen, um einige wenige Fahrzeugfunktionen bedienen zu können, sind heute in Kraftfahrzeugen eine Vielzahl von Assistenzsystemen, aber auch Entertainmentsysteme und Multimediasysteme integriert, über die sich fahrzeuginterne und fahrzeugexterne Funktionen und Dienste bedienen lassen. Beispielsweise weist eine Vielzahl von Kraftfahrzeugen heutzutage Bedienelemente auf, die in ein Lenkrad oder eine Lenkradoberfläche integriert sind. Um die Eingabemöglichkeiten, insbesondere eine Flexibilisierung der Eingabemöglichkeiten, zu steigern und eine möglichst intuitive Bedienung von Fahrzeugfunktionen und/oder Systemen sowie fahrzeugexternen oder mit Fahrzeugen gekoppelten Systemen zu ermöglichen, ist es wünschenswert, auch berührungsempfindliche Sensoren an Stellen im Kraftfahrzeug zu integrieren, die eine stark gekrümmte Oberfläche aufweisen. An diesen Stellen ist eine Integration von berührungsempfindlichen Sensoren bisher nicht befriedigend gelöst.

Aus der US 2016/0170498 A1 ist eine Dateneingabevorrichtung bekannt, die ein Gehäuse mit einer Vorderseite und einer Rückseite und seitlich voneinander getrennten Griffabschnitten aufweist. An den Griffabschnitten kann der Nutzer das Gehäuse halten und zugleich mit seinen Fingern Bedienelemente betätigen, die teilweise auf der Vorderseite und teilweise auf der Rückseite ausgebildet sind. Ein Teil dieser an der Vorder- und der Rückseite ausgebildeten Tasten können als berührungsempfindliche Tasten ausgebildet sein. Beschrieben ist ferner, dass in das Gehäuse berührungsempfindliche Flächen integriert sein können. Die Vorrichtung ist ferner vorzugsweise so ausgebildet, an der Vorderseite in der Mitte zwischen den Griffabschnitten ein Mobiltelefon oder ein Tablet aufzunehmen.

Aus der US 2010/0103138 A1 ist ein Verfahren zum Herstellen eines gekrümmten Touchpads und ein solches Touchpad bekannt, bei denen eine flexible Platinenschicht hinter eine gekrümmte Oberfläche mittels Formpressung angeordnet wird.

Die CN 203799363 A1 beschreibt eine Vorrichtung mit einem gekrümmten eine Bedienoberfläche aufweisenden Gehäuse, hinter dem beabstandet eine flache Platine mit Schaltungsanordnung angeordnet ist, die mehreren Sensoren umfasst, die nach einem kapazitiven Messprinzip messen. Die einzelnen Sensoren sind jeweils einer Berührtaste auf der Bedienoberfläche zugeordnet. Zwischen jedem Sensor und der zugeordneten Berührtaste ist jeweils ein elastisches Schwammelement angeordnet, das an seiner Oberfläche mit einem leitfähigen Material beschichtet ist. Hierüber wird eine elektrische Verbindung zwischen der Platine und dem Gehäuse ausgebildet.

Die EP 2 256 602 A2 beschreibt eine Bedienoberfläche mit berührungsempfindlichen Bedienelementen, deren Bedienung nach einem kapazitiv wirkenden Messprinzip erfasst wird. Zwischen einer gekrümmten Bedienoberfläche und einer flachen Platine mit einzelnen kapazitiven Sensoren wird ein Silikon-Schnittstellenelement mit einer flachen Basis auf einer Seite und Säulen auf der gegenüberliegenden Seite angeordnet. Das Anordnen erfolgt so, dass von dem Silikon-Schnittstellenelements an einer von der Patine abgewandten Seite über jedem Sensor eine Säule angeordnet ist, die den Sensor mit einer Rückseite der gekrümmten Bedienoberfläche an jener Stelle verbindet, an der ein Bedienelement auf einer Vorderseite der Bedienoberfläche vorgesehen ist.

Sowohl die CN 203799363 A1 als auch die EP 2 256 602 A2 sehen eine feste Zuordnung von Sensorelement zu Bedienelement vor.

Aus der US 9,256,325 B2 ist eine Vorrichtung mit einer gekrümmten Anzeigefläche bekannt, auf die von hinten ein Bild projizierbar ist. Ferner ist auf der Rückseite eine Infrarotkamera angeordnet, welche Berührungen der gekrümmten Oberfläche erkennen kann und deren Berührposition ermitteln kann. Die auf die Anzeigefläche von hinten projizieren Informationen können abhängig von den erfassten Berührpositionen verändert werden.

Aus der EP 2 130 113 B1 ist eine elektrische Steuereinrichtung für ein Automobil bekannt, die einen Sensor mit einer Berührungsoberfläche umfasst, der Resistenzen verwendet, die druckempfindlich sind und sich mit einem Träger verbinden, der eine dreidimensionale Oberfläche, vertieft oder vorspringend, aufweist, wobei die Berühroberfläche des Sensors eine Form aufweist, die derart gestaltet ist, dass im zusammengebauten Zustand mindestens ein Teil der gestalteten Berührungsoberflächen aufeinander treffen, indem sie sich der Form der dreidimensionalen Oberfläche anpassen, um eine Berührungsoberfläche zu bilden, die im Wesentlichen fortlaufend ist, wobei die gestaltete Berührungsoberfläche eine vordefinierte Anzahl von Kreisbogenstreifen aufweist, deren kleinen gewölbten Seiten mit einer gemeinsamen Basis verbunden sind und die Form einer Scheibe aufweisen, sodass sich die Berührungsoberfläche einem Träger anpasst, der eine vertiefte Oberfläche mit kegelstumpfartiger Form aufweist. Eine alternative Ausführungsform sieht vor, dass die gestaltete Berührungsoberfläche eine vordefinierte Anzahl von Kreisbogenstreifen aufweist, deren große gewölbte Seiten mit einer gemeinsamen Basis verbunden sind und eine parallelepipedische Form aufweisen, sodass sich die Berühroberfläche einem Träger anpasst, der eine vertiefte Oberfläche mit kegelstumpfartiger Form aufweist.

Die bekannten Ausführungsformen weisen den Nachteil auf, dass in der Regel nur regelmäßig geformte, beispielsweise in einer Richtung gekrümmte, Oberflächen mit berührungsempfindlichen ortsaufgelösten Sensorfolien versehen werden können.

Der Erfindung liegt somit die Aufgabe zugrunde, eine Vorrichtung für eine berührungsempfindliche ortsaufgelöste Nutzereingabemöglichkeit zu schaffen, die eine Freiformoberfläche aufweist.

Die Erfindung wird durch eine Vorrichtung mit den Merkmalen des Patentanspruchs 1 sowie ein Verfahren mit den Merkmalen des Patentanspruchs 10 gelöst. Vorteilhafte Ausgestaltungen der Erfindung ergeben sich aus den Unteransprüchen.

Der Erfindung liegt der Gedanke zugrunde, bekannte in der Regel flach ausgebildete berührungsempfindliche Sensoren für die Nutzereingabeerfassung zu verwenden und diese beabstandet von einer Freiformfläche anzuordnen. Um die Berührung an der Freiformfläche sensieren zu können, werden zwischen der Freiformfläche und der Sensorfläche der Positionserfassungseinrichtung eine Vielzahl von Vermittlungselementen angeordnet, die jeweils zwei gegenüberliegende Enden aufweisen. Ein Ende wird an oder in der Freiformfläche angeordnet und das gegenüberliegende Ende an der Sensorfläche der Positionserfassungseinrichtung. So wird es möglich, Berührungen an der Freiformfläche quasi über die Vermittlungselemente zu der Sensorfläche zu übertragen. Hierdurch wird es möglich, in großer Stückzahl hergestellte und kostengünstige Positionserfassungseinrichtungen, die für eine berührungsempfindliche ortsaufgelöste Erfassung ausgebildet sind, mit beliebigen Freiformflächen zu kombinieren und kostengünstige Vorrichtungen für eine ortsaufgelöste Berührungserfassung an einer Freiformfläche zu schaffen.

Es ist vorgesehen, eine Vorrichtung mit einer berührungsempfindlichen Freiformfläche zu schaffen, die eine Freiformfläche als äußere Fläche und eine Positionserfassungseinrichtung mit einer Sensorfläche umfasst, gemäss Anspruch 1. Den Orten auf der Sensorfläche sind somit Orte auf der Freiformfläche zugeordnet, sodass anhand der ermittelten "Berührposition" auf der Sensorfläche die Position auf der Freiformfläche eindeutig ermittelbar ist. Hierdurch wird es möglich, nahezu beliebig geformte Oberflächen, beispielsweise von Bedienmodulen in einem Kraftfahrzeuglenkrad, mit einer sogenannten Touchfähigkeit auszubilden.

Ein besonderer Vorteil besteht darin, dass auch Oberflächenstrukturen mit kleinen Krümmungsradien und sogar Oberflächen mit Kanten und Ecken für eine ortsaufgelöste Berührungserfassung ausgebildet werden können. Dieses ist eine enorme Verbesserung gegenüber dem Stand der Technik, bei dem beispielsweise berührungsempfindliche ortsauflösende Sensorfolien an die Freiformfläche angepasst und angeformt werden müssen. Besonders bevorzugt ist die Sensorfläche plan ausgebildet, sodass in großer Stückzahl hergestellte und kostengünstige Positionserfassungseinrichtungen verwendet werden können. Auch bei einer plan ausgeführten Sensorfläche der Positionserfassungseinrichtung kann die Freiformfläche beliebig gestaltet und dennoch für eine ortsaufgelöste Berührungserfassung ausgebildet sein. Selbst senkrecht zur Sensorfläche orientiert Flächenabschnitte oder hinterschnittene Flächenabschnitte der Freiformfläche können berührungsempfindlich ausgebildet werden oder sein.

Bei besonders bevorzugten Ausführungsformen ist die Freiformfläche dreidimensional ausgestaltet. Dies bedeutet, dass bezogen auf ein kartesisches Koordinatensystem keine ebene Fläche existiert, in der sämtliche Erfassungspositionen der Oberfläche der Freiformfläche liegen. Somit können für die Haptik geeignete Oberflächenformen gewählt werden, die beispielsweise eine haptische Orientierung ohne Blickzuwendung, d.h. beispielsweise auch ohne eine Blickabwendung vom Verkehr, ermöglichen.

Besonders bevorzugt sind auf der Freiformfläche ein oder mehrere als Vertiefungen oder Vorsprünge ausgebildete Bedienbereiche ausgebildet. Besonders bevorzugt weist die Freiformfläche somit Mulden, welche als Vertiefungen ausgebildet sind, und/oder Vorwölbungen auf. Dies bietet den Vorteil, dass eine haptische und optische Orientierung eines Nutzers auf einfache Weise möglich ist.

Um die Berührung an der Freiformfläche zu der Sensorfläche der Positionserfassungseinrichtung zu übermitteln, sind die Vermittlungselemente vorzugsweise elektrisch leitfähig. Dieses erlaubt den Einsatz einer Vielzahl von Positionserfassungseinrichtungen, die elektrische Eigenschaften an oder über der Sensorfläche auswerten.

Bei einer einfachen Ausführungsform sind die Vermittlungselemente in einem regelmäßigen Raster angeordnet. Zu deren Ausbildung können beispielsweise metallische Stifte in einem regelmäßigen Raster angeordnet und in einem isolierenden Formkörper gehalten sein.

Die Freiformfläche kann beispielsweise durch ein spanabhebendes Verfahren geschaffen werden, in dem sowohl Formkörper als auch die darin gehaltenen Metallstifte selbst bearbeitet werden, um die Freiformfläche bzw. deren Kontur zu schaffen. Dieses Verfahren lässt es zu, anhand von Rohlingen, d.h. von Formkörpern mit im Innern ausgebildeten oder gehaltenen Vermittlungselementen, auf einfache Weise individuelle Freiformflächen zu gestalten.

Bei einigen Ausführungsformen sind die Vermittlungselemente zumindest Abschnittsweise durch Luft gegeneinander isoliert. Beispielsweise können in einem Körper aus isolierendem Material gehaltene oder gehalterte Metallstifte in hohle Kanäle eines Formkörpers eingreifen, ohne die Kanalwände zu berühren oder zumindest über Abschnitte des Kanals umlaufend beabstandet von den Kanalwänden angeordnet sein.

Um eine ansprechende Oberfläche zu schaffen und diese gegen äußere Beanspruchungen zu schützen, ist bei einer Ausführungsform vorgesehen, dass die Freiformfläche eine aus einem isolierenden Material gebildete Schutzschicht aufweist. Diese kann beispielsweise aus einer dünnen Lederschicht, einer glatten oder aufgerauten Kunststoffschicht bestehen. Andere Ausführungsformen sehen eine Lackschicht, beispielsweise aus einem Kunstharzmaterial, vor. Die Schutzschicht kann auch mittels eines Holzfurniers ausgebildet sein.

Ein weiterer Vorteil einer isolierenden Schutzschicht besteht darin, dass die Vorrichtung gegen elektrostatische Entladungen (ESD - engl. electro static discharge) geschützt ist.

Bei einer anderen Ausführungsform sind die Vermittlungselemente zumindest abschnittsweise als leitfähige Kanäle in einem isolierenden Formkörper ausgebildet, dessen mindestens eine Oberfläche eine Kontur der Freiformfläche folgt bzw. diese festlegt. Ein solcher Formkörper kann beispielsweise in einem Spritzguss- oder Spritzprägeverfahren hergestellt werden. Hierbei können im Innern nicht miteinander verbundene Kanäle ausgebildet werden, die mit einem leitfähigen Material verfüllt werden. Auch das Verfüllen der Kanäle mit dem leitfähigen Material, beispielsweise einem Kunststoffmaterial, dem Metall- oder Kunststoffpartikel zugesetzt sind, kann in einem Spritzguss- oder Spritzprägeverfahren erfolgen.

Der Formkörper kann jedoch auch durch spanabhebende Verfahren geformt und über Bohrungen mit Kanälen versehen werden, die dann beispielsweise mit einem mit leitfähigen Partikeln versehenen Kunststoffmaterial, beispielsweise einem Kunstharz, verfüllt werden. Wesentlich ist, dass die einzelnen ausgebildeten Kanäle gegeneinander elektrisch isoliert sind.

Auch Formkörper mit Vermittlungselementen in Form von leitfähigen, gegeneinander isolierten Kanälen können als Rohlinge mit einer Grundform hergestellt werden. Die Freiformfläche kann dann anschließend mit einem spanabhebenden oder anders ausgebildeten Verfahren geformt werden.

Eine andere Möglichkeit eine körperliche Struktur auszubilden, die die Kontur der Freiformfläche festlegt und zugleich die Vermittlungselemente oder Abschnitte hiervon umfasst, besteht darin, in einem zunächst isolierenden Formkörper durch gezielte lokale Beaufschlagung mit einem elektrischen und/oder magnetischen Feld leitfähige Kanäle auszubilden. Ein elektrisches Feld kann beispielsweise lokal durch ein Anlegen einer Spannung zwischen zwei Elektroden ausgebildet werden, die auf einander entgegengesetzten Oberflächen des Formkörpers angeordnet sind oder an diesen angreifen. Es kann vorteilhaft sein, zusätzlich Wärmeenergie zuzuführen, um den Prozess des Ausbildens leitfähiger, gegeneinander isolierter Kanäle zu begünstigen. Beispielsweise können bei einem solchen Prozess zunächst homogen dispergierte Teilchen lokal umgeordnet werden, so dass Vermittlungselemente für eine kapazitive Kopplung entsteht.

Die Erfindung bietet jedoch auch die Möglichkeit, relativ große Flächen der Freiformfläche mit der berührungsempfindlichen ortsauflösenden Eigenschaft zu versehen, obwohl nur eine mit einer wesentlich kleineren Sensorfläche ausgebildete Positionserfassungseinrichtung verwendet wird. Dies wird dadurch möglich, dass die Erfassungspositionen, denen erste Enden der Vermittlungselemente zugeordnet sind, eine geringere Flächendichte aufweisen als die Sensorpositionen, denen die entsprechenden zweiten Enden der Vermittlungselemente zugeordnet sind. Ebenso ist es jedoch auch möglich, in bestimmten Bereichen der Freiformfläche eine höhere Flächendichte an Erfassungspositionen zu schaffen, denen erste Enden unterschiedlicher Vermittlungselemente zugeordnet sind, als die entsprechende Flächendichte an Sensorpositionen der entsprechenden zweiten Enden der Vermittlungselemente.

Darüber hinaus müssen die Vermittlungselemente nicht als gradlinige Metallstifte oder gradlinige Kanäle ausgebildet sein. Beispielsweise können die Verbindungselemente abschnittsweise als isolierte Drähte ausgeführt sein. Somit ist es möglich, die Freiformfläche beweglich gegenüber der Positionserfassungseinrichtung zu lagern, an dessen Oberfläche oder benachbart zu dieser Oberfläche die zweiten Enden der Vermittlungselemente angeordnet sind. So kann beispielsweise ein weiterer Formkörper ausgebildet sein, in dem die zweiten Enden der Vermittlungselemente gehalten sind und an einer Sensorkontaktfläche enden. Diese ist vorzugsweise plan ausgebildet, sodass sie sich gegenüber einer ebenfalls plan ausgebildeten Sensorfläche einfach anordnen lässt.

Darüber hinaus können auch geschlossene, beispielsweise zylinderförmige oder um einen Lenkstock oder Lenkstockhebel umlaufende, Flächen mit einer Berührungsempfindlichkeit versehen werden.

Ein Verfahren zum Herstellen einer Vorrichtung mit einer berührungsempfindlichen Freiformfläche umfasst ein Bereitstellen oder Ausbilden einer Positionserfassungseinrichtung gemäss Anspruch 10.

Eine bevorzugte Ausführungsform sieht vor, dass das Integrieren der Verbindungselemente in die körperliche Struktur ein Ausbilden eines Formkörpers umfasst, in dem voneinander getrennte Kanäle ausgebildet werden, in die die Vermittlungselemente eingebracht werden.

Bei einer Ausführungsform ist vorgesehen, dass der Formkörper mittels eines Spritzguss- oder Spritzprägeverfahrens hergestellt wird. Hierdurch können kostengünstige, formstabile Formkörper hergestellt werden.

Bei einer Weiterbildung ist es möglich, auch die Vermittlungselemente mittels eines leitfähigen Kunststoffs ebenfalls in einem Gieß- und/oder Spritzprägeverfahrensschritt in den Formkörper zu integrieren.

Die Vermittlungselemente, insbesondere wenn diese als metallische Stifte oder Pins ausgebildet sind, können somit in einen Formkörper eingegossen sein. Dieser kann anschließend bearbeitet werden, um die Kontur der Freiformfläche zu definieren.

Andere Ausführungsformen sehen vor, dass die Vermittlungselemente mittels eines leitfähigen Kunststoffs ausgebildet werden.

Bei einigen Ausführungsformen kann einer körperliche Struktur, die die Freiformfläche so wie die Verbindungelementen enthält, eine oder mehrere Formkörper umfassen, die die Vermittlungselemente halten. Bei einigen Ausführungsformen ist ein Formkörper so ausgestaltet, dass dieser die ersten Enden der Vermittlungselemente hält und zugleich der Kontur der Freiformfläche, welche mit einer ortauflösenden, berührungsempfindlichen Eigenschaft versehen ist, folgt oder diese Kontur festlegt.

Bei einigen Ausführungsformen ist vorgesehen, dass die körperliche Struktur einen weiteren Formkörper umfasst, in dem die zweiten Enden der Vermittlungselemente gehalten werden. Der weitere Formkörper weist somit eine Sensorkontaktfläche auf, die vor der Sensorfläche der Positionserfassungseinrichtung angeordnet ist. Weist die körperliche Struktur zwei Formkörper oder zwei voneinander getrennte Formkörperteile auf, so kann ein Teil oder Abschnitt eines der Verbindungelemente durch einen isolierten Draht- oder einen Kabelabschnitt gebildet sein. Hierüber wird es möglich die Freiformfläche in der körperlichen Struktur beweglich gegenüber der Sensorkontaktfläche zu lagern. In dem ersten Formkörper sind erste Endabschnitte und in dem weiteren Formkörper zweite Endabschnitte gehalten. Die ersten Endabschnitte sind dann mit den zweiten Endabschnitten über Kabel- oder Drahtabschnitte miteinander verbunden.

Die ersten Endabschnitte können auch als flächige Berührsegmente und die zweiten Endabschnitte als Sensorsegment des jeweiligen Vermittlungselements ausgebildet sein. Das Berührungssegment und das Sensorsegment sind jeweils vorzugsweis als elektrischer Kontakt ausgebildet.

Bei einigen Ausführungsformen sind zumindest die zweiten Enden der Vermittlungselemente leitend mit Elektroden oder Elektrodenelementen der Positionserfassungseinrichtung verbunden.

Andere Ausführungsformen sehen jedoch vor, dass zwischen den Elektroden der Positionserfassungseinrichtung und den Vermittlungselementen keine elektrisch leitende Verbindung besteht, sondern dass nur eine Kapazitive Kopplung sattfindet. Dieses bietet einen verbesserten Schutz gegen elektrostatische Entladungen (ESD). Ferner wird die Kopplung zwischen den Vermittlungselementen und Sensorfläche der Positionserfassungseinrichtung deutlich vereinfacht. Somit ist eine Anordnung eines Formkörpers mit den Vermittlungselementen oder einer körperlichen Struktur mit den Vermittlungselementen relativ zu der Sensorfläche der Positionserfassungseinrichtung leichter. Kleinere Positionierungsabweichungen von einer Sollpositionierung können toleriert werden und gegebenenfalls über eine Kalibration korrigiert werden. Hierbei wird die Zuordnung von Sensorpositionen auf der Sensorfläche zu Berührpositionen an der Freiformfläche angepasst. Dieses kann ohne mechanische Nachjustierung erfolgen.

Einen besonders guten Schutz gegen Beschädigungen aufgrund elektrostatische Entladungen (ESD) erreicht man, wenn die Vermittlungselemente gegenüber der äußeren Oberfläche der Freiformfläche als auch gegenüber den Elektroden der Positionserfassungseinrichtung elektrisch isoliert sind. Die Isolation an der Oberfläche der Freiformfläche erreicht man beispielsweise über die bereits erwähnte Schutzschicht aus einem isolierenden Lack, einem dünnen Holzfurnier, einer dünnen Kunststoffschicht etc. Die Isolation an der Positionserfassungseinrichtung kann durch eine Schutzfolie oder eine Glasscheibe, wie diese in vielen Positionserfassungseinrichtungen vorhanden sind, oder auch durch einen Luftspalt oder eine andere elektrisch isolierende Schicht realisiert sein, die oder der jeweils zwischen den zweiten Enden der Vermittlungselemente und den Elektroden der Positionserfassungseinrichtung angeordnet sind.

Grundsätzlich ist es somit bei den meisten Ausführungsformen weder notwendig, dass ein elektrisch leitender Kontakt zwischen einem Betätigungselement eine Nutzers, beispielsweise einem Finger, und einem Vermittlungselement bei der Berührungserfassung an der Freiformfläche hergestellt wird, noch notwendig, dass ein elektrisch leitender Kontakt zwischen dem Betätigungselement und einer Elektrode der Positionserfassungseinrichtung bei der Berührung ausgebildet wird. Die ortsaufgelöste Positionserfassung an der Oberfläche der Freiformfläche erfolgt dann über eine kapazitive Kopplung des Betätigungselements an die Positionserfassungseinrichtung über die Vermittlungselemente.

Es sind auch Ausführungsformen möglich, bei denen die Vermittlungselemente nicht durchgehend leitend ausgebildet sind, sondern beispielsweise nur abschnittsweise, wobei die Abschnittsenden und- anfänge so benachbart angeordnet sind, dass eine kapazitive Kopplung entlang der gesamten Erstreckung eines Vermittlungselements bei einer Berührung erfolgt.

Ein körperliche Struktur und insbesondere ein Formkörper kann auch in einem additiven Herstellungsverfahren, beispielsweise in einem 3D-Druckverfahren, hergestellt werden. Hierbei werden vorzugsweise elektrisch isolierende und elektrisch leitende Materialien gemeinsam verarbeitet, um die Freiformflächenkontur festzulegen und zugleich die hiermit gekoppelten Vermittlungselemente auszubilden, die die Freiformfläche mit der Sensorkontaktfläche verbinden.

Die Positionsermittlungseinrichtung ist vorzugsweise auf einer Platine ausgebildet. Diese umfasst vorzugsweis die Auswerteelektronik. Um die Positionserfassungseinheit signaltechnisch mit anderen Komponenten zu koppeln, weist die Platine vorzugsweise Steckkontakte auf.

Bei einigen Ausführungsformen stellt ein ebenfalls auf der Platine vorzugsweise ausgebildetes Kommunikationsmodul einen Treiber für ein Bussystem oder Ähnliches bereit.

Die Positionserfassungseinrichtung ist vorzugsweise eine mehrfach-berührungsempfindliche ortsauflösende Erfassungseinrichtung, die zeitgleich mehrere Berührpositionen ortsaufgelöst erfassen kann. Über die Zuordnung der ersten Enden der Vermittlungselement zu Erfassungspositionen auf der Freiformfläche und eine Zuordnung der zweiten Enden zu Sensorpositionen auf der Sensorfläche der Positionserfassungseinrichtung ist es somit über die Anordnung und Zuordnung der Vermittlungselemente möglich, von den ermittelten "Berührpositionen" auf der Sensorfläche auf die Berührpositionen der Freifläche zurückzuschließen.

Eine Ausführungsform sieht vor, dass eine Interpolation der Berührposition auf der Freifläche anhand der auf der Sensorfläche ermittelten (über die Vermittlungselemente übertragenen oder projizierten) "Berührposition" vorgenommen wird. Somit ist eine bessere Ortauflösung möglich als durch die Anzahl der ersten Enden der Vermittlungselemente bzw. zugeordneten Erfassungspositionen vorgegeben ist.

Eine hohe Flexibilisierung der Bedienoberfläche auf der Freiformfläche wird dadurch ermöglicht, dass die Vermittlungselemente so angeordnet und ausgebildet werden, dass eine Flächendichte der Erfassungsposition auf der Freiformfläche zumindest in einem Abschnitt von einer flächendichte der Sensorpositionen an der Sensorfläche der Positionserfassungseinrichtung abweicht. Einzelne Bereich der Freiformfläche können somit eine hohe Auflösung andere eine niedrigere Auflösung besitzen, dafür aber eine größere Fläche überdecken.

Eine Vorrichtung mit einer ortsaufgelöst berührungsempfindlichen Freiformfläche kann unterschiedliche Ausprägungen annehmen. Beispielsweise kann eine solche Vorrichtung als Bestandteil einer Lenkung eines Kraftfahrzeugs ausgebildet sein. Beispielsweise kann eine solche Vorrichtung als ein Lenkstockhebel, als ein Lenkradkranz, als ein Bedienmodul einer Lenkradspeiche usw. ausgebildet sein.

Eine weitere Ausführungsform sieht vor, dass eine Sensorfläche der Positionserfassungseinrichtung ein Touchscreen ist und die Freiformfläche nur einen Teil der Sensorfläche überdeckt. Somit ist ein Bereich des Touchscreen als solcher nutzbar. In dem überdeckten Bereich kann die Freiformfläche jedoch haptisch gut zu erfassende Eingabebereiche, beispielsweise in Form von vertiefen Flächen oder Mulden, vorzugsweise mit abgerundeten Wällen oder Wänden, in Form von Vorwölbungen oder langgestreckten Vertiefungen usw., aufweisen. Hierdurch werden die Vorteile eines Touchscreen mit den Vorteilen einer haptisch ertastbaren Bedienoberfläche kombiniert. Zusätzlich zu dem Touchscreen ist keine weitere Positionserfassungseinrichtung notwendig.

Die berührungsempfindliche Freiformfläche (d.h. der Berührungsempfindliche Flächenbereich) kann hierbei eine größere flächige Ausdehnung aufweisen als der vom Touchscreen überdeckte Bereich.

Vorzugsweise ist die Freiformfläche, die den Touchscreen überdeckt nicht transparent. Dieses gilt insbesondere, wenn die berührungsempfindliche Freiformfläche einen Flächenbereich aufweist, der größer als der überdeckte Touchscreenbereich der Sensorfläche ist, da dann ohnehin für einen Betrachter keine einfache optische Zuordnung einer Berührposition auf der Freiformfläche zu einer Darstellungsposition auf dem Touchscreen möglich ist. Die Freiformfläche kann jedoch auch in anderen Ausführungen opak ausgebildet sein.

Die Erfindung wird nachfolgend unter Bezugnahme auf eine Zeichnung näher erläutert. Hierbei zeigen:
- Fig. 1: eine schematische Schnittansicht einer Vorrichtung mit einer berührungsempfindlichen Freiformfläche;
- Fig. 2: ein schematisch dargestelltes Lenkrad mit zwei Lenkraderfassungsmodulen;
- Fig. 3a-3d: schematische Darstellungen zur Erläuterung einer Ausführungsform einer Vorrichtung mit einer berührungsempfindlichen Freiformfläche;
- Fig. 4a-4d: schematische Darstellungen einer Ausführungsform einer Vorrichtung mit einer berührungsempfindlichen Freiformfläche, bei der der berührungsempfindliche Bereich auf der Freiformfläche flächig größer ausgebildet ist als eine Sensorfläche der Positionserfassungseinrichtung;
- Fig. 5: schematische Darstellungen zur Erläuterung einer weiteren Ausführungsform einer Vorrichtung mit einer berührungsempfindlichen Freiformfläche;
- Fig. 6: eine schematische Darstellung einer Vorrichtung, bei der die Freiformfläche eine Kugeloberfläche aufweist;
- Fig. 7: eine schematische Ansicht eines Endes eines Lenkstockhebels;
- Fig. 8: eine Schnittansicht durch den Lenkstockhebel nach Fig. 7; und
- Fig. 9: eine schematische Draufsicht auf ein mit einer Freiformfläche ausgestaltetes Lenkradbedienmodul.

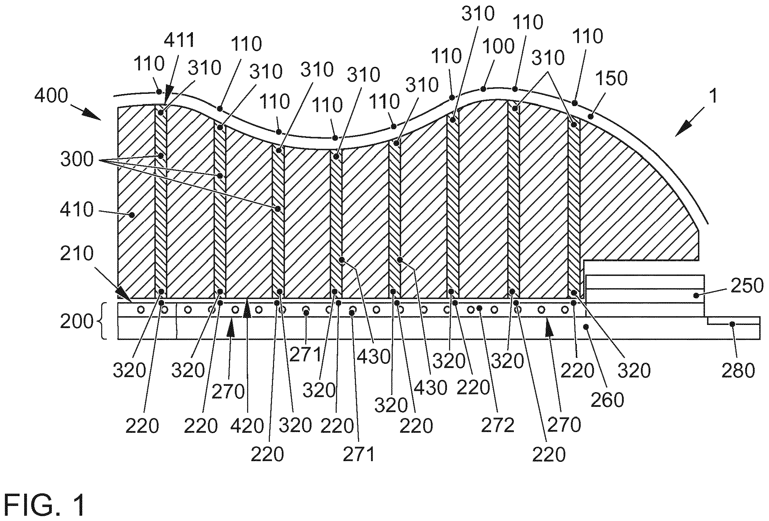

In Fig. 1 ist schematisch eine Vorrichtung 1 mit einer berührungsempfindlichen äußeren Freiformfläche 100 schematisch dargestellt. Berührungsempfindlich bedeutet in diesem Zusammenhang, dass Berührpositionen zumindest in einzelnen Flächenbereichen der Freiformfläche 100 ortsaufgelöst erfasst werden können. Die Vorrichtung 1 umfasst neben der äußeren Freiformfläche 100 eine Positionserfassungseinrichtung 200, welche ausgebildet ist, an einer Sensorfläche 210 Berührpositionen ortsaufgelöst zu erfassen. Um zu erreichen, dass Berührungen an der äußeren Freiformfläche 100 durch die Positionserfassungseinrichtung 200 ortsaufgelöst erfasst werden können, sind zwischen der äußeren Freiformfläche 100 und der Positionserfassungseinrichtung 200 voneinander getrennt ausgebildete Vermittlungselemente 300 vorgesehen. Die Vermittlungselemente 300 weisen jeweils ein erstes Ende 310 und ein gegenüberliegendes zweites Ende 320 auf. Die ersten Enden 310 enden an oder in der äußeren Freiformfläche 100. Die entgegengesetzten zweiten Enden 320 enden an oder auf der Positionserfassungseinrichtung 200 an der Sensoroberfläche 210. Die ersten Enden 310 sind somit Erfassungspositionen 110 an der äußeren Freiformfläche zugeordnet, während die entsprechenden zweiten Enden 320 Sensorpositionen 220 auf der Sensorfläche 210 zugeordnet sind.

An dieser Stelle wird darauf hingewiesen, dass die Zuordnung der zweiten Enden zu Sensorpositionen in der Regel unabhängig von einer inneren Struktur der Positionserfassungseinrichtung erfolgt. Eine Sensorposition ist lediglich eine Position auf der Sensorfläche.

In der dargestellten Ausführungsform sind die Vermittlungselemente 300 in einer körperlichen Struktur 400 angeordnet, der als Formkörper 410 ausgebildet ist. Dieser ist vorzugsweise aus einem isolierenden Material, vorzugsweise Kunststoff, Holz oder einem anderem Verbundwerkstoff, gebildet. Eine Oberfläche 411 folgt der äußeren Freiformfläche 100 oder legt diese äußere Freiformfläche 100 oder dessen Kontur fest. In der dargestellten Ausführungsform weist die Vorrichtung 1 an der Freiformfläche 100 eine aus einem isolierenden Material gebildete Abdeckschicht 150 auf. Diese kann beispielsweise aus einer dünnen Lederschicht oder einer Kunststoffschicht oder auch aus einer Lackschicht bestehen.

Die Vermittlungselemente 300 können als metallische Stifte oder Pins ausgebildet sein. Die Stifte oder Pins sind beispielsweise in ein Kunststoffmaterial des Formkörpers 410 eingegossen. Bei anderen Ausführungsformen sind die in dem Formkörper 410 gebildeten Kanäle 430 mit einem leitfähigen Kunststoffmaterial, beispielsweise einem Kunstharz, gefüllt, dem leitende Partikel, beispielsweise Metallspäne, insbesondere Eisenspäne, Silberspäne, Kupferspäne, Goldspäne oder Kohlenstoffteilchen, zugefügt sind. Die einzelnen Kanäle 430 in dem Formkörper 410 sind gegeneinander abgeschlossen und durchdringen sich nicht, sodass beim Verfüllen leitende Vermittlungselemente 300 gebildet werden, die gegeneinander elektrisch isoliert sind. Findet an der Freiformfläche 100 eine Berührung statt, so findet über die Vermittlungselemente 300 eine kapazitive Kopplung an in der Erfassungseinrichtung 200 ausgebildeten Elektroden 271/272, die vorzugsweise in Spalten- und Zeilenform angeordnet sind, statt. Eine Auswerteelektronik 250 ist in der Lage, die kapazitive Kopplung zwischen den sich kreuzenden Spaltenelektroden 271 und Reihenelektroden 272 auszuwerten und hierdurch eine Berührposition zu ermitteln. Diese wird als Positionssignal an Anschlusskontakten 280 beispielsweise als elektronisches Signal bereitgestellt. Die Anschlusskontakte 280 sind auf einer Platine 260 ausgebildet, auf der das Elektrodenmuster 270 in Form der sich kreuzenden Reihen- und Spaltenelektroden 271, 272 ausgebildet ist. Auch die Auswerteelektronik 250 ist auf der Platine 260 ausgebildet.

Der Formkörper 410 ist an einer Sensorkontaktfläche 420 plan ausgebildet, sodass die körperliche Struktur 400 mit der Freiformfläche 100 optimal auf der Sensorfläche 210 angeordnet werden kann, welche ebenfalls eben ausgebildet ist.

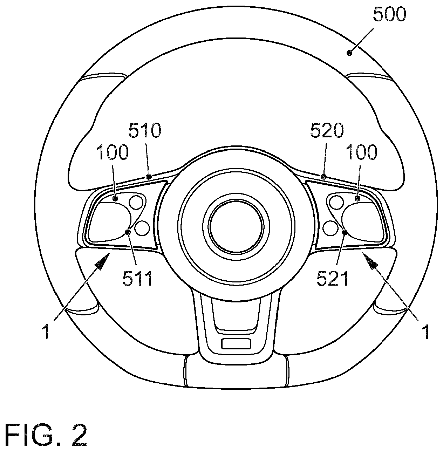

In Fig. 2 ist schematisch ein Lenkrad 500 eines Kraftfahrzeugs dargestellt. In einer linken Lenkradspeiche 510 ist ein linkes Lenkradbedienmodul 511 und in der rechten Lenkradspeiche 520 ein rechtes Lenkradbedienmodul 521 gezeigt. Das linke Lenkradbedienmodul 511 und das rechte Lenkradbedienmodul 521 stellen jeweils Vorrichtungen 1 mit einer berührungsempfindlichen Freiformfläche 100 im Sinne der hier beschriebenen Erfindung dar. Gleiche technische Merkmale sind in den Figuren mit denselben Bezugszeichen gekennzeichnet.

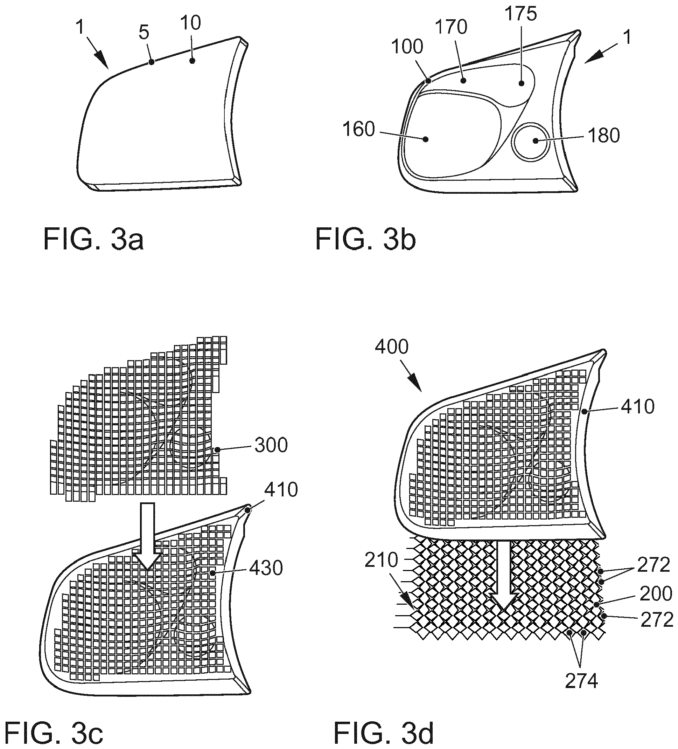

Anhand von Fig. 3a-3d soll ein schematischer Aufbau einer solchen Vorrichtung 1 schematisch erläutert werden. Eine äußere Kontur 5 der Vorrichtung 1 ist durch den Bauraum in der Speiche 510 des Lenkrads 500 (vergleiche Fig. 2) vorgegeben. Eine obere äußere Oberfläche ist ausgehend von einer leicht nach außen aus der Zeichnungsfläche herausgewölbten Oberfläche 10 gebildet. Eine solche Oberfläche ist exemplarisch in Fig. 3a gezeigt. In dieser äußeren Oberfläche 10, welche die Freiformfläche 100 der Vorrichtung 1 bildet, sind jeweils als Vertiefungen eine Aktivierungsfläche 160, eine eher langgestreckte Schiebereglerfläche 170 mit einer Abschlussmulde 175 sowie eine Knopfmulde 180 ausgebildet.

In einen Formkörper 410, dessen äußere Oberfläche die beschriebene Freiformfläche 100 aufweist und dessen Unterseite (nicht dargestellt) flach ausgebildet ist, werden in einem regelmäßigen Raster Kanäle 430 ausgebildet. Diese Kanäle sind vorzugsweise als Durchgangslöcher ausgebildet, diese können jedoch an der Unterseite bei einigen Ausführungsformen auch eine dünne Materialschicht als Abschluss enthalten, sodass diese Kanäle Sacklöcher bilden. In die Kanäle 430 werden leitfähige Verbindungselemente 300 eingefügt. Beispielsweise kann dies erfolgen, indem die Kanäle mit einem leitfähigen Material, beispielsweise einem Kunstharz, gefüllt werden, denen Metallpartikel oder Kohlenstoffpartikel zugefügt sind. Alternativ können in ihrer Länge an die Kanäle angepasste Metallstifte in die Kanäle 430 eingebracht werden.

Alternativ ist es möglich, zunächst einen Rohling eines Formkörpers mit darin eingeschlossenen, z.B. eingegossenen, voneinander getrennten leitfähigen Elementen zu bilden und anschließend in einem spanabhebenden Verfahren die äußere Freiformfläche 100 zu formen, sodass sowohl die Verbindungselemente 300 als auch die Bereiche des Formkörpers 410 zwischen den Vermittlungselementen 300 die entsprechende Freiformflächenkontur enthalten. Der Formkörper 410 mit den leitfähigen Vermittlungselementen 300, der eine körperliche Struktur 400 bildet, wird abschließend auf einer Positionserfassungseinrichtung 200 mit der flachen Unterseite aufgebracht, sodass an der äußeren Freiformfläche 100 erfolgende Berührungen über die Vermittlungselemente 300 an den Elektroden 271, 272 der Positionserfassungseinrichtung 200 Kapazitätsänderungen auslösen, sodass die Positionserfassungseinrichtung 200 die mittels der Vermittlungselemente 300 quasi in die Sensorfläche 210 der Positionseinrichtung 240 projizierten Berührpositionen ermitteln kann. Über die Geometrie der Vermittlungselemente 300 können Berührpositionen auf der Sensorfläche 210 eindeutig Berührpositionen auf der Freiformfläche 100 zugeordnet werden.

Abhängig von der Geometrie und Ausgestaltung der Vermittlungselemente bzw. der Freiformoberfläche kann eine Ortsauflösung auf der Freiformoberfläche höher oder geringer als eine Ortsauflösung auf der Sensorfläche der Positionserfassungseinrichtung sein.

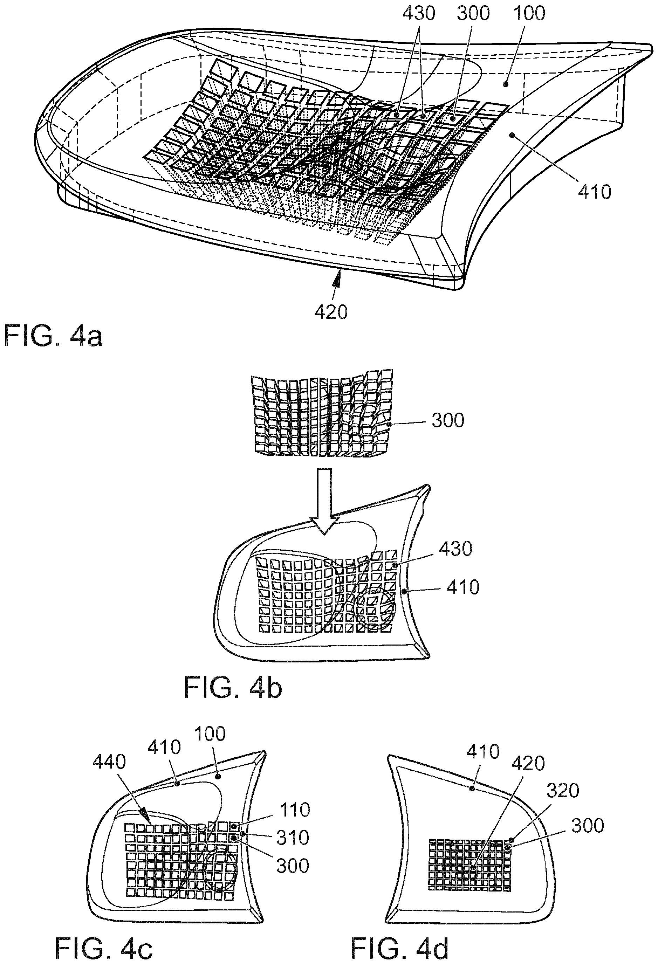

Dies soll exemplarisch anhand von Fig. 4a-4d erläutert werden. Dort ist in Fig. 4a schematisch ein Formkörper 410 einer als Lenkradbedienmodul ausgebildeten Vorrichtung 1 mit einer berührungsempfindlichen Freiformfläche 100 schematisch dargestellt. Die einzelnen Kanäle 430 erstrecken sich von einer an der Unterseite ausgebildeten Sensorkontaktfläche 420 nicht senkrecht nach oben, sondern verlaufen jeweils leicht angeschrägt nach außen. Dies ist für die Kanäle 430 und die Vermittlungselemente 300 schematisch in Fig. 4b dargestellt.

In Fig. 4c ist die Draufsicht auf die Freiformfläche 100 dargestellt. Gut zu erkennen sind die Querschnittsflächen der ersten Enden 310 der Vermittlungselemente 300. Eine berührungsempfindliche Gesamtfläche 440, über die sich die Erfassungspositionen 110 verteilen, welche mit den ersten Enden 310 der Vermittlungselemente 300 verknüpft sind bzw. welchen diese ersten Enden 310 zugeordnet sind, ist größer als eine Sensorkontaktfläche 420. In Fig. 4d ist die ebene Unterseite des Formkörpers 410 mit den darin ausgebildeten zweiten Enden 320 der Vermittlungselemente 300 gezeigt, die die Größe der Sensorkontaktfläche 420 anzeigen. Deutlich zu erkennen ist, dass eine von den zweiten Enden 320 eingenommene Fläche wesentlich kleiner ist. Hieraus ergibt es sich, dass eine Ortsauflösung auf der Freiformfläche 100 geringer als eine Ortsauflösung an der Sensorfläche der Positionserfassungseinrichtung sein wird, auf der die von den zweiten Enden 320 der Vermittlungselemente 300 gebildete Sensorkontaktfläche 420 gesetzt ist.

Bei den dargestellten Ausführungsformen der Fig. 3a bis 3d und Fig. 4a bis 4d ragten die Vermittlungselemente jeweils bündig in die Freiformfläche der Vorrichtung hinein. In der Regel ist es jedoch bevorzugt, dass eine die Optik und Haptik ansprechende äußere Oberfläche auf der Freiformfläche ausgebildet ist bzw. diese bildet. Hierfür eignen sich dünne Schichten, die aus Leder, Holz, Kunststoff oder auch als Lackschicht ausgebildet sind.

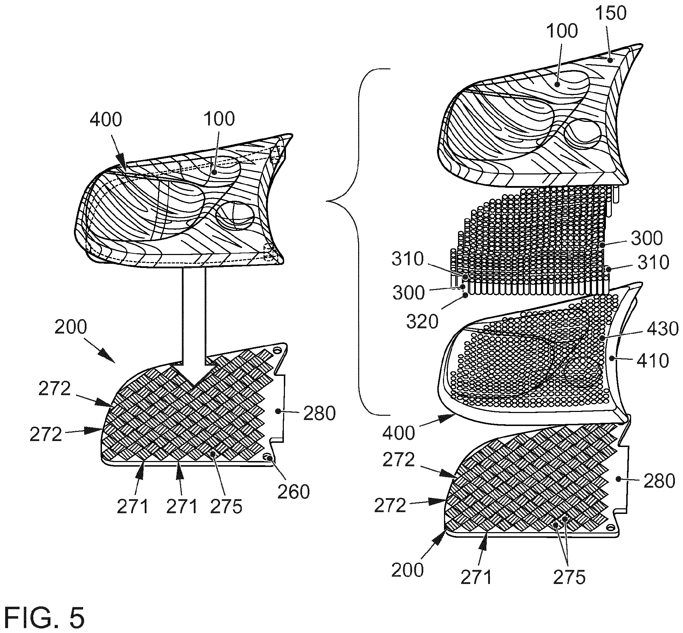

In Fig. 5 ist der modulare Aufbau aus der körperlichen Struktur 400, welche eine Freiformoberfläche 100 und Vermittlungselemente 300 umfasst, welche an einer ebenen unteren Seite mit ihren zweiten Enden 320 enden, und einer Positionserfassungseinrichtung 200, welche vorzugsweise auf einer Platine 260 ausgebildet ist, schematisch dargestellt. Die Positionserfassungseinrichtung weist in der Regel rautenförmige Elektrodenelemente 275 auf, die vorzugsweise zu Reihen 727 und hierzu senkrecht verlaufenden Spalten 271 miteinander verbunden sind. Auf der Platine ist ferner die Auswerteelektronik (nicht dargestellt) angeordnet, welche die über die Vermittlungselemente 300 auf die Positionserfassungseinrichtung 200 "projizierte" Berührungsposition ermitteln kann und als elektronisches Signal bereitstellt. Vorzugsweise ist die Elektronik mit einem Kommunikationsmodul (nicht dargestellt) ausgerüstet, welches beispielsweise standardisierte Signale über ein Fahrzeugbussystem, beispielsweise einen CAN-Bus, einen FlexRay-Bus, LIN-Bus oder Ähnlichen, austausche kann. Für die elektrische Spannungsversorgung und signaltechnische Verknüpfung sind an der Platine 260 Anschlusskontakte 280 ausgebildet.

Auf der rechten Seite ist eine Explosionszeichnung der körperlichen Struktur 400 gezeigt, die die äußere Schutzschicht 150, die elektrisch leitfähigen, getrennt voneinander ausgebildeten Vermittlungselemente 300 sowie einen Formkörper 410 zum Halten der Vermittlungselemente 300 und Festlegen der Kontur der äußeren Freiformfläche 100 aufweist. Diese körperliche Struktur 400 ist auf der Positionserfassungseinrichtung 200 angeordnet und vorzugsweise fest mit dieser verbunden, beispielsweise verschraubt, verklebt oder Ähnliches.

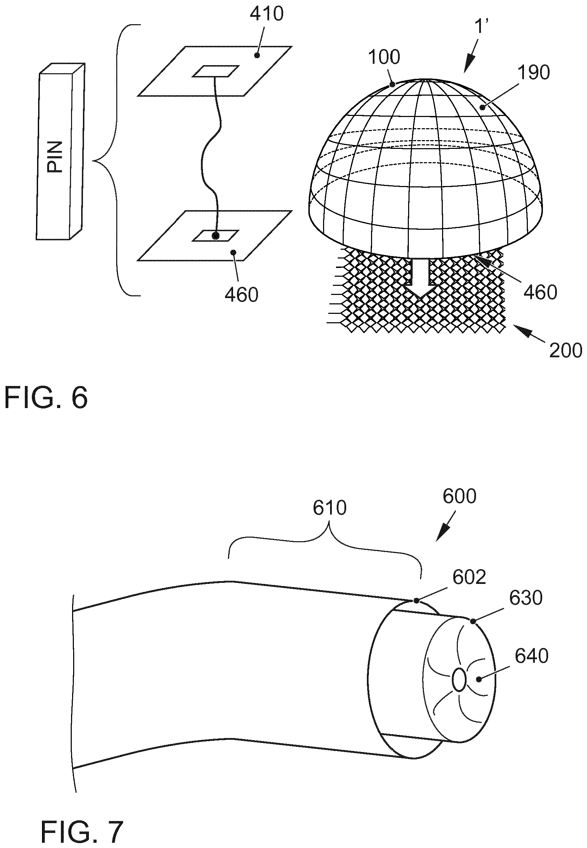

In Fig. 6 ist eine weitere schematische Darstellung einer Vorrichtung 1 mit einer äußeren Freiformfläche 100 in Form einer Halbkugel dargestellt. Einzelnen Kugeloberflächenelementen 190 sind einzelne leitfähige Berührungssegmente 311, welche vorzugsweise an einer Innenseite eines Formkörpers 410 ausgebildet sind, zugeordnet. Diese sind beispielsweise mittels eines isolierten Drahts 330 jeweils mit einer weiteren Kontaktfläche, einem Sensorsegment 321, verbunden und bilden ein Vermittlungselement 300. Hierbei sind die Sensorsegmente 321 vorzugsweise in einem flächig ausgebildeten weiteren Formkörper 460 gehaltert. Unterhalb des weiteren Formkörpers 460 ist erneut eine Positionserfassungseinrichtung 200, wie oben beschrieben, angeordnet.

Es lassen sich jedoch auch andere komplizierte Freiformflächen, welche gegebenenfalls teilweise gegeneinander bewegbar gelagert sind, mittels einer gemeinsamen Positionserfassungseinrichtung verbinden und zu einer gemeinsamen Vorrichtung mit einer berührungsempfindlichen Freiformoberfläche zusammenfassen. Beispielsweise kann eine solche Vorrichtung als Lenkstockhebel 600 ausgebildet sein, wie dieser in Fig. 7 dargestellt ist. Dieser Lenkstockhebel 600 umfasst ein zylinderförmig ausgebildeten Endabschnitt 610, an dessen Außenfläche Berührpositionen ortsaufgelöst erfasst werden können. Darüber hinaus ist an einem Ende 602 des Lenkstockhebels eine Endkappe 630 angeordnet, welche mit einer nach innen gewölbten berührungsempfindlichen Mulde ausgebildet ist.

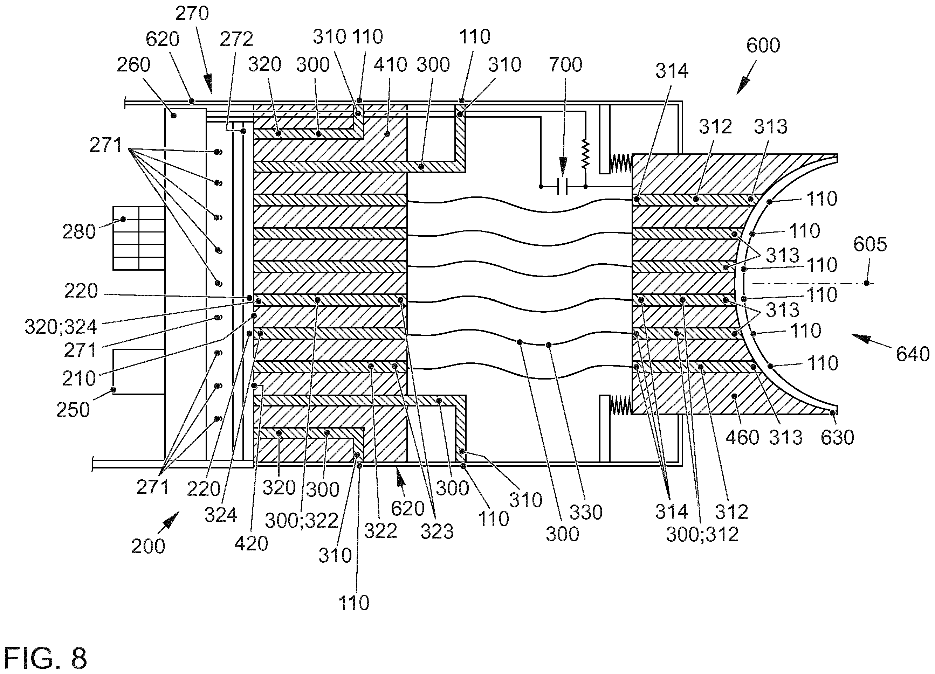

In Fig. 8 ist eine schematische Schnittansicht eines solchen Lenkstockhebels dargestellt. Im Innern des Lenkstockhebels 600 sind in einem ersten Formkörper 410 Vermittlungselemente 300 gehalten, deren erste Enden 310 an Erfassungspositionen 110 einer Mantelfläche 620 enden. Zweite Enden 320 der Vermittlungselemente 300 enden an einer Sensorkontaktfläche 420 des ersten Formkörpers 410. In einem weiteren Formkörper 460 sind erste Endabschnitte 312 von weiteren Vermittlungselementen 301 gehaltert. Diese erste Endabschnitte 312 enden jeweils an einer Muldenfläche 645 der Mulde 640 der Endkappe 630. Die Endkappe 630 ist federbelastet gegenüber dem Rest des Lenkstockhebels 600 gelagert und kann beim Drücken Endkappe 630 in den Lenkstockhebel einfedern und einen Tippkontakt (nicht dargestellt) schließen.

In dem ersten Formkörper 410 sind ferner zweite Endabschnitte 322 der Vermittlungselemente 301 gehaltert, deren zweite Enden 324 an der Sensorkontaktfläche 420 enden. Erste Enden 323 der zweiten Endabschnitte 322 sind über isolierte Draht- oder Kabelabschnitte 330 mit zweiten Enden 314 der ersten Endabschnitte elektrisch leitend verbunden. Die ersten Enden 313 der ersten Endabschnitte 312 sind Erfassungspositionen 110 der Muldenfläche 645 zugeordnet. Somit ist sind die Vermittlungselemente 301, die aus den ersten Endabschnitten 312, den Kabelabschnitten 330 und den zweiten Endabschnitten 322 bestehen, mit der Positionserfassungseinrichtung gekoppelt. Die Positionserfassungseinrichtung 200 mit ihrer Sensorfläche 210 ist so angeordnet, dass eine Oberflächennormale der Sensorfläche 210 parallel zu einer Zylinderachse 605 der zylindrischen Mantelfläche 620 orientiert ist. Die Positionserfassungseinrichtung 200 ist erneut auf einer Platine 260 ausgebildet, auf der die Auswerteelektronik 250 sowie gegebenenfalls nötige Bustreiber ausgebildet sind, um über Anschlusskontakte 280 eine Verbindung mit einem Fahrzeugbus und/oder einem Steuergerät herstellen zu können.

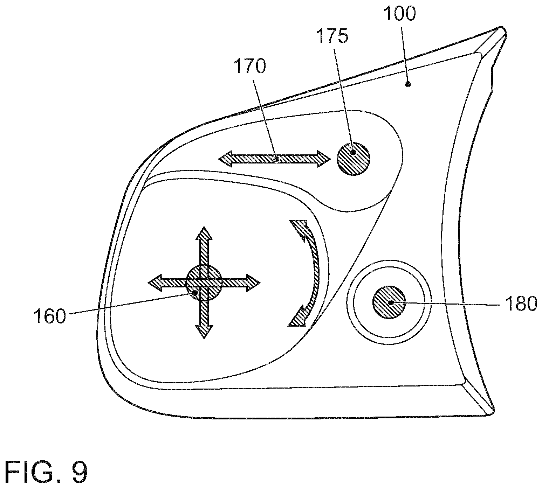

Anhand von Fig. 9 sollen die verschiedenen Eingabemöglichkeiten mit dem in Fig. 2 bis Fig. 5 beschriebenen Lenkradbedienmodul erläutert werden. Auf der Aktionsfläche 160 können sowohl horizontale als auch vertikale Wischbewegungen sowie drehende Bewegungen einfach und zuverlässig erfasst werden. Darüber hinaus können ein- und mehrfach Tippgesten erfasst werden. Vorzugsweise ist die Positionserfassungseinrichtung als Multitoucheinrichtung ausgebildet, sodass diese zeitgleich eine Vielzahl von Berührpositionen erfassen kann. Auf der Aktionsfläche können somit auch einfache mit zwei Fingern ausführbare Bediengesten wie ein Spreizen und Zusammenschieben, das Parallelführen von mehreren Fingern usw. als Berührgesten erfasst werden. In der langgestreckten Schiebereglerfläche 170 werden vorzugseise Schiebebewegungen entlang der langgestreckten Muldenrichtung erfasst. Die Abschlussmulde 175 ist vorzugsweise für eine Einfach- oder Doppeltippgestenerfassung ausgebildet. Die Knopfmulde 180 ist schließlich vorzugsweise für Einfach-, Doppel- oder Trippeltippgestenerfassung ausgebildet.

An dem in Fig. 7 und 8 beschriebenen Lenkstockhebel 600 können an der Mantelfläche 620 im Endabschnitt 610 stattfindende Berührungen von Fingern ortsaufgelöst erfasst werden. Ferner können mit den Fingern um die Zylinderachse 605 ausgeführte Drehbewegungen auf der Mantelfläche als auch axial ausgeführte Schiebebewegungen parallel zur Zylinderachse 605 erfasst werden. In der Muldenfläche 645 können Einfach- oder Mehrfachtippbewegungen unabhängig und zusätzlich zu einer möglichen zusätzlichen Betätigung des federbelastenden Tippschalters erfasst werden, wobei der Tippschalter durch ein Eindrücken der Endkappe 630 gegen die Federbelastung betätigbar ist. Bei anderen Ausführungsformen kann die Endkappe 630 auch einstückig mit der Mantelfläche 620 ausgebildet sein, sodass die Einfach- oder Mehrfachtippberührung, welche in der Muldenfläche 645 erfasst wird, ein Auslösen des Tippschalters ersetzen kann.

Um eine Kopplung der Vermittlungselemente an die Positionserfassungseinrichtung zu verbessern, ist bei einigen Ausführungsformen vorgesehen, dass die Vermittlungselemente mit Elektrodenflächen der Positionserfassungseinrichtung elektrisch leitend gekoppelt sind. Bei einer solchen Ausführungsform ist eine Anordnung und Ausbildung der zweiten Enden an der Kontaktfläche an das Elektrodenmuster der Positionserfassungseinrichtung anzupassen, was sonst nicht notwendig ist.

Insgesamt wird durch die Erfindung die Möglichkeit geschaffen, sehr flexible Freiformflächen zu bilden und beispielsweise in Cockpits von Kraftfahrzeugen oder anderen Fahrzeugen zu integrieren. Es ist ebenfalls möglich, beispielsweise in einem Armaturenbrett an verschiedenen Stellen oder über das gesamte Armaturenbrett verteilt berührungsempfindliche Bereiche auszubilden, indem in diesen erste Kontaktflächen in der Freiformfläche oder angrenzend an die Freiformfläche angeordnet werden und über leitfähige Verbindungsabschnitte mit zweiten Kontaktflächen verbunden werden, die angrenzend an einen ortsauflösenden Positionserfassungssensor angeordnet sind. Hierdurch wird eine große Freiheit und Flexibilität für die Gestaltung von Bedienoberflächen in einem Kraftfahrzeugcockpit geschaffen.

Dadurch, dass eine körperliche Struktur die Freiformfläche festlegt und die Vermittlungselemente umfasst, kann die Freiformfläche in der Regel von einer Positionserfassungseinrichtung leicht getrennt werden. Es wird die Möglichkeit geschaffen mit der Positionserfassungseinrichtung verschiedene Freiformflächen alternativ zu koppeln. Hierdurch wird eine Flexibilisierung für die Cockpitgestaltung geschaffen. Die mit der Freiformfläche versehenen körperlichen Strukturen, in denen die Vermittlungselemente ausgebildet sind, können auf einfache Weise in Spritzgussverfahren kostengünstig in großer Stückzahl hergestellt werden. Auch alternativ hergestellte Ausführungsformen, bei denen über spanabhebende Verfahren Freiformflächen aus Rohlingen mit im Innern angeordneten leitfähigen Kanälen oder Stiften geschaffen werden, können mit einer standardisierten Positionserfassungseinrichtung gekoppelt werden, sodass auch individualisierte Einzelanfertigungen, beispielsweise individuell angepasste Freiformflächen, in Cockpitumgebungen eingesetzt werden können.

Es versteht sich, dass die oben beschriebenen Ausführungsformen nur beispielhafte Ausführungsformen sind und die Erfindung auf eine Vielzahl weiterer Freiformflächen angewendet werden kann.

### Bezugszeichenliste

- 1: Vorrichtung mit berührungsempfindlicher Freiformfläche
- 5: äußere Kontur
- 10: Oberfläche
- 100: Freiformfläche
- 110: Erfassungsposition
- 150: Abdeckschicht
- 160: Aktivierungsfläche
- 170: Schiebereglerfläche
- 175: Abschlussmulde
- 180: Knopfmulde
- 190: Kugeloberflächenelement
- 200: Positionserfassungseinrichtung
- 210: Sensorfläche
- 220: Sensorpositionen
- 250: Auswerteelektronik
- 260: Platine
- 270: Elektrodenmuster
- 271: Spaltendetektoren
- 272: Reihendetektoren
- 275: Elektrodenelemente
- 280: Anschlusskontakte
- 300: Vermittlungselemente
- 301: Vermittlungselemente
- 310: erste Enden
- 311: Berührungssegment
- 312: erste Endabschnitte
- 313: erste Enden
- 314: zweite Enden
- 320: zweite Enden
- 321: Sensorsegment
- 322: zweite Endabschnitte
- 323: erste Enden
- 324: zweite Enden
- 330: Kabelabschnitte
- 400: körperliche Struktur
- 410: (erster) Formkörper
- 411: Oberfläche
- 420: Sensorkontaktfläche
- 430: Kanäle
- 440: berührungsempfindliche Gesamtfläche
- 460: weiterer Formkörper
- 500: Lenkrad
- 510: linke Speiche
- 511: linkes Lenkraderfassungsmodul
- 520: rechte Speiche
- 521: rechtes Lenkraderfassungsmodul
- 600: Lenkstockhebel
- 602: Ende
- 605: Zylinderachse
- 610: Endabschnitt
- 620: Mantelfläche
- 630: Endkappe
- 640: Mulde
- 645: Muldenfläche

## Patentansprüche

1. Vorrichtung (1) mit berührungsempfindlicher Freiformfläche (100), umfassend
die Freiformfläche (100) als äußere Fläche; und
eine Positionserfassungseinrichtung (200) mit einer Sensorfläche (210), wobei
die Sensorfläche (210) und die Freiformfläche (100) eine voneinander abweichende geometrische Gestalt aufweisen und zwischen der Sensorfläche (210) und der Freiformfläche (100) eine Vielzahl von Vermittlungselementen (300) angeordnet sind, die jeweils ein erstes Ende (310) und ein entgegengesetztes zweites Ende (320) aufweisen, wobei die ersten Enden (310) unterschiedlichen Erfassungspositionen (110) auf der Freiformfläche (100) zugeordnet sind und die zweiten Enden (320) unterschiedlichen Sensorpositionen (220) auf der Sensorfläche (210) der Positionserfassungseinrichtung (200) zugeordnet sind, so dass Berührungen der Freiformfläche (100) über die Vermittlungselemente (300) zu der Sensorfläche (210) übermittelbar sind und von der Positionserfassungseinrichtung (200) ortsaufgelöst erfassbar sind, **dadurch gekennzeichnet, dass** die Positionserfassungseinrichtung in einem Elektrodenmuster (270) angeordnete Elektroden (271, 272) und eine mit den Elektroden (271, 272) gekoppelte Auswerteelektronik aufweist, wobei die Auswerteelektronik ausgebildet ist, die bei der Berührung der Freiformfläche (100) über die Vermittlungselemente (300) stattfindende kapazitive Kopplung der Elektroden (271, 272) der Positionserfassungseinrichtung (200) auszuwerten und hierdurch die Berührposition zu ermitteln.

2. Vorrichtung (1) nach Anspruch 1, **dadurch gekennzeichnet, dass** Sensorfläche (210) plan ausgebildet ist.

3. Vorrichtung (1) nach Anspruch 1 oder 2, **dadurch gekennzeichnet, dass** die Freiformfläche (100) eine dreidimensionale Gestalt aufweist.

4. Vorrichtung (1) nach einem der Ansprüche 1 bis 3, **dadurch gekennzeichnet, dass** Sensorfläche (210) der Positionserfassungseinrichtung (200) ein Touchscreen ist und die Freiformfläche nur einen Teil der Sensorfläche (210) überdeckt.

5. Vorrichtung (1) nach einem der Ansprüche 1 bis 4, **dadurch gekennzeichnet, dass** die Vermittlungselemente (300) elektrisch leitfähig sind.

6. Vorrichtung (1) nach einem der Ansprüche 1 bis 5, **dadurch gekennzeichnet, dass** die Vermittlungselemente (300) in einem regelmäßigen Raster angeordnet sind.

7. Vorrichtung (1) nach einem der Ansprüche 1 bis 6, **dadurch gekennzeichnet, dass** die Freiformfläche (100) Öffnungen aufweist, in die die Vermittlungselemente (300) eingefügt sind.

8. Vorrichtung (1) nach einem der Ansprüche 1 bis 6, **dadurch gekennzeichnet, dass** die Freiformfläche (100) eine aus einem isolierenden Material gebildet Schutzschicht (150) aufweist.

9. Vorrichtung (1) nach einem der Ansprüche 1 bis 8, **dadurch gekennzeichnet, dass** die Vermittlungselemente (300) zumindest abschnittsweise als leitfähige Kanäle (340) in einem isolierenden Formkörper ausgebildet sind, dessen mindestens eine Oberfläche einer Kontur der Freiformfläche folgt oder diese festlegt.

10. Verfahren zur Herstellung eines Vorrichtung (1) mit berührungsempfindlicher
Freiformfläche (100), umfassend die Schritte:
Bereitstellen oder Ausbilden einer Positionserfassungseinrichtung (200) mit einer Sensorfläche;
Ausbilden einer körperlichen Struktur mit einer Freiformfläche (100) und Integrieren einer Vielzahl von voneinander getrennten Vermittlungselementen (300) in die körperliche Struktur (400), die jeweils ein erstes Ende (310) und ein
entgegengesetztes zweites Ende (320) aufweisen, wobei die ersten Enden (310) unterschiedlichen Erfassungspositionen (110) auf der Freiformfläche (100) zugeordnet sind und die zweiten Enden (320) an unterschiedlichen Positionen einer Sensorkontaktfläche (420) enden und die körperliche Struktur (400) und die Positionserfassungseinrichtung (200) so zueinander angeordnet werden, dass die Sensorfläche (210) und die Sensorkontaktfläche (420) aneinandergrenzen, so dass Berührungen der Freiformfläche (100) über die Vermittlungselemente (300) zu der Sensorfläche (210) übermittelt werden und von der Positionserfassungseinrichtung (200) ortsaufgelöst erfassbar sind, **dadurch gekennzeichnet, dass** die Positionserfassungseinrichtung in einem Elektrodenmuster (270) angeordnete Elektroden (271, 272) und eine mit den Elektroden (271, 272) gekoppelte Auswerteelektronik aufweist, wobei die Auswerteelektronik ausgebildet ist, die bei der Berührung der Freiformfläche (100) über die Vermittlungselemente (300) stattfindende kapazitive Kopplung der Elektroden (271, 272) der Positionserfassungseinrichtung (200) auszuwerten und hierdurch die Berührposition zu ermitteln.

11. Verfahren nach Anspruch 10, **dadurch gekennzeichnet, dass** die Vermittlungselemente (300) leitfähig ausgebildet werden.

12. Verfahren nach Anspruch 10 oder 11, **dadurch gekennzeichnet, dass** das Ausbilden der körperlichen Struktur (400) das Bilden eines Formkörpers (410) umfasst, in dem voneinander getrennte Kanäle (420) ausgebildet werden, in die die Vermittlungselemente (300) eingebracht werden.

13. Verfahren nach einem der Ansprüche 10 bis 12, **dadurch gekennzeichnet, dass** die Vermittlungselemente (300) in die Kanäle (420) eingegossen oder gespritzt werden.

14. Verfahren nach einem der Ansprüche 10 bis 13, **dadurch gekennzeichnet, dass** der Formkörper (410) mittels eines Spritzguss- oder Spritzpräge-Verfahren hergestellt wird.

15. Verfahren nach einem der Ansprüche 10 bis 14, **dadurch gekennzeichnet, dass** die Vermittlungselemente mittels eines leitfähigen Kunststoffs ausgebildet werden.

## Claims

1. Device (1) with a touch-sensitive free-form surface (100), comprising the free-form surface (100) as the outer surface; and
a position detection unit (200) with a sensor surface (210),
wherein
the sensor surface (210) and the free-form surface (100) have different geometrical shapes and arranged between the sensor surface (210) and the free-form surface (100) are a plurality of relaying elements (300) each of which comprises a first end (310) and an opposing second end (320), wherein the first ends (310) are assigned to different detection positions (110) on the free-form surface (100), and the second ends (320) are assigned to different sensor positions (220) on the sensor surface (210) of the position detection unit (200), so that touches on the free-form surface (100) can be transmitted via the relaying elements (300) to the sensor surface (210) and can be detected in a spatially resolved manner by the position detection unit (200), **characterized in that** the position detection unit comprises electrodes (271, 272) arranged in an electrode pattern (270) and evaluation electronics coupled to the electrodes (271, 272), wherein the evaluation electronics are designed to evaluate the capacitive coupling of the electrodes (271, 272) of the position detection unit (200), which takes place when the free-form surface (100) is touched via the relaying elements (300), and to thereby determine the touch position.

2. Device (1) according to Claim 1, **characterized in that** the sensor surface (210) is of planar design.

3. Device (1) according to Claim 1 or 2, **characterized in that** the free-form surface (100) has a three-dimensional form.

4. Device (1) according to one of Claims 1 to 3, **characterized in that** the sensor surface (210) of the position detection unit (200) is a touchscreen, and the free-form surface only covers a part of the sensor surface (210).

5. Device (1) according to one of Claims 1 to 4, **characterized in that** the relaying elements (300) are electrically conductive.

6. Device (1) according to one of Claims 1 to 5, **characterized in that** the relaying elements (300) are arranged in a regular grid.

7. Device (1) according to one of Claims 1 to 6, **characterized in that** the free-form surface (100) comprises openings into which the relaying elements (300) are inserted.

8. Device (1) according to one of Claims 1 to 6, **characterized in that** the free-form surface (100) comprises a protective layer (150) formed from an insulating material.

9. Device (1) according to one of Claims 1 to 8, **characterized in that** the relaying elements (300) are formed at least in segments as conductive channels (340) in an insulating moulded body whose at least one surface follows or specifies a contour of the free-form surface.

10. Method for the manufacture of a device (1) with a touch-sensitive free-form surface (100), comprising the following steps:
provision or formation of a position detection unit (200) with a sensor surface;
formation of a physical structure with a free-form surface (100) and integration of a large number of mutually separate relaying elements (300) into the physical structure (400), each of which comprises a first end (310) and an opposing second end (320), wherein the first ends (310) are assigned to different detection positions (110) on the free-form surface (100) and the second ends (320) terminate at different positions of a sensor contact surface (420) and the physical structure (400) and the position detection unit (200) are arranged with respect to one another in such a way that the sensor surface (210) and the sensor contact surface (420) are adjacent to one another, so that touches to the free-form surface (100) are transmitted via the relaying elements (300) to the sensor surface (210) and can be detected in a spatially resolved manner by the position detection unit (200), **characterized in that** the position detection unit comprises electrodes (271, 272) arranged in an electrode pattern (270) and evaluation electronics coupled to the electrodes (271, 272), wherein the evaluation electronics are designed to evaluate the capacitive coupling of the electrodes (271, 272) of the position detection unit (200), which takes place when the free-form surface (100) is touched via the relaying elements (300), and to thereby determine the touch position.

11. Method according to Claim 10, **characterized in that** the relaying elements (300) are formed conductively.

12. Method according to Claim 10 or 11, **characterized in that** the formation of the physical structure (400) comprises the formation of a moulded body (410) in which mutually separate channels (420) are formed into which the relaying elements (300) are introduced.

13. Method according to one of Claims 10 to 12, **characterized in that** the relaying elements (300) are cast or injected into the channels (420).

14. Method according to one of Claims 10 to 13, **characterized in that** the moulded body (410) is manufactured by means of an injection moulding or injection stamping method.

15. Method according to one of Claims 10 to 14, **characterized in that** the relaying elements are formed by means of a conductive plastic.

## Revendications

1. Dispositif (1) comportant une surface de forme libre sensible au toucher (100), comprenant la surface de forme libre (100) en tant que surface externe ; et
un dispositif de détection de position (200) comportant une surface de capteur (210),
dans lequel la surface de capteur (210) et la surface de forme libre (100) ont une forme géométrique différente et entre la surface de capteur (210) et la surface de forme libre (100) une pluralité d'éléments de commutation (300) sont disposés, qui présentent chacun une première extrémité (310) et une deuxième extrémité opposée (320), dans lequel les premières extrémités (310) sont affectées à des positions de détection différentes (110) sur la surface de forme libre (100) et les deuxièmes extrémités (320) sont affectées à des positions de capteur différentes (220) sur la surface de capteur (210) du dispositif de détection de position (200), de sorte que les contacts de la surface de forme libre (100) puissent être transmis via les éléments de commutation (300) à la surface du capteur (210) et puissent être détectés d'une manière résolue spatialement par le dispositif de détection de position (200), **caractérisé en ce que** le dispositif de détection de position présente des électrodes (271, 272) agencées en un motif d'électrodes (270) et une électronique d'évaluation couplée aux électrodes (271, 272), dans lequel l'électronique d'évaluation est conçue pour évaluer le couplage capacitif des électrodes (271, 272) du dispositif de détection de position (200) se produisant lorsque la surface de forme libre (100) est touchée via les éléments de commutation (300) et ainsi pour déterminer la position de contact.

2. Dispositif (1) selon la revendication 1, **caractérisé en ce que** la surface du capteur (210) est plane.

3. Dispositif (1) selon la revendication 1 ou 2, **caractérisé en ce que** la surface de forme libre (100) a une forme tridimensionnelle.

4. Dispositif (1) selon une des revendications 1 à 3, **caractérisé en ce que** la surface de capteur (210) du dispositif de détection de position (200) est un écran tactile et la surface de forme libre ne recouvre qu'une partie de la surface de capteur (210).

5. Dispositif (1) selon une des revendications 1 à 4, **caractérisé en ce que** les éléments de commutation (300) sont électriquement conducteurs.

6. Dispositif (1) selon une des revendications 1 à 5, **caractérisé en ce que** les éléments de commutation (300) sont disposés selon un maillage régulier.

7. Dispositif (1) selon une des revendications 1 à 6, **caractérisé en ce que** le
la surface de forme libre (100) présente des ouvertures dans lesquelles les éléments de commutation (300) sont insérés.

8. Dispositif (1) selon une des revendications 1 à 6, **caractérisé en ce que** la surface de forme libre (100) comporte une couche de protection (150) formée d'un matériau isolant.

9. Dispositif (1) selon une des revendications 1 à 8, **caractérisé en ce que** les éléments de commutation (300) sont formés au moins par tronçons sous forme de canaux conducteurs (340) dans un corps moulé isolant, dont au moins une surface suit ou définit un contour de la surface de forme libre.

10. Procédé de fabrication d'un dispositif (1) comportant une surface de forme libre sensible au toucher (100), comprenant les étapes de:
fourniture ou formation d'un dispositif de détection de position (200) comportant une surface de capteur ;
formation d'une structure physique avec une surface de forme libre (100) et
intégration d'une pluralité d'éléments de commutation (300) séparés les uns des autres dans la structure physique (400), qui présentent chacun une première extrémité (310) et une deuxième extrémité opposée (320), dans lequel les premières extrémités (310) sont affectées à des positions de détection différentes (110) sur les surfaces de forme libre (100) et les deuxièmes extrémités (320) aboutissent à des positions différentes d'une surface de contact du capteur (420) et la structure physique (400) et le dispositif de détection de position (200) sont agencés les uns par rapport aux autres de telle sorte que la surface de capteur (210) et la surface de contact de capteur (420) soient contiguës, de sorte que les contacts de la surface de forme libre (100) soient transmis via les éléments de commutation (300) à la surface de capteur (210) et puissent être détectés d'une manière résolue spatialement par le dispositif de détection de position (200), **caractérisé en ce que** le dispositif de détection de position présente des électrodes (271, 272) agencées en un motif d'électrodes (270) et une électronique d'évaluation couplée aux électrodes (271, 272), dans lequel l'électronique d'évaluation est conçue pour évaluer le couplage capacitif des électrodes (271, 272) du dispositif de détection de position (200) se produisant lorsque la surface de forme libre (100) est touchée via les éléments de commutation (300) et ainsi pour déterminer la position de contact.

11. Procédé selon la revendication 10, **caractérisé en ce que** les éléments de commutation (300) peuvent être rendus conducteurs.

12. Procédé selon la revendication 10 ou 11, **caractérisé en ce que** la formation de la structure physique (400) comprend la formation d'un corps moulé (410), dans lequel des canaux séparés (420) sont formés, dans lesquels les éléments de commutation (300) sont introduits.

13. Procédé selon une quelconque des revendications 10 à 12, **caractérisé en ce que** les éléments de commutation (300) sont coulés ou injectés dans les canaux (420).

14. Procédé selon une quelconque des revendications 10 à 13, **caractérisé en ce que** le corps moulé (410) est produit au moyen d'un moulage par injection ou d'un moulage par injection-compression.

15. Procédé selon une quelconque des revendications 10 à 14, **caractérisé en ce que** les éléments de commutation sont réalisés au moyen d'une matière plastique conductrice.
